(19) **Europäisches Patentamt / European Patent Office / Office européen des brevets**

(11) **EP 1 865 095 A2**

(12) # EUROPEAN PATENT APPLICATION

(43) Date of publication:
**12.12.2007 Bulletin 2007/50**

(51) Int Cl.:
***C30B 29/40*** *(2006.01)*     ***C30B 25/04*** *(2006.01)*
***C30B 25/02*** *(2006.01)*

(21) Application number: **07010274.4**

(22) Date of filing: **23.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **08.06.2006 JP 2006159880**

(71) Applicant: **Sumitomo Electric Industries, Ltd.**
**Osaka-shi, Osaka 541-0041 (JP)**

(72) Inventors:
- **Okahisa, Takuji**
  **Itami-shi**
  **Hyogo 664-0016 (JP)**
- **Motoki, Kensaku**
  **Itami-shi**
  **Hyogo 664-0016 (JP)**
- **Uematsu, Koji**
  **Itami-shi**
  **Hyogo 664-0016 (JP)**
- **Nakahata, Seiji**
  **Itami-shi**
  **Hyogo 664-0016 (JP)**

- **Hirota, Ryu**
  **Itami-shi**
  **Hyogo 664-0016 (JP)**
- **Ijiri, Hideyuki**
  **Itami-shi**
  **Hyogo 664-0016 (JP)**
- **Kasai, Hitoshi**
  **Itami-shi**
  **Hyogo 664-0016 (JP)**
- **Fujita, Shunsuke**
  **Itami-shi**
  **Hyogo 664-0016 (JP)**
- **Sato, Fumitaka**
  **Itami-shi**
  **Hyogo 664-0016 (JP)**
- **Matsuoka, Toru**
  **Itami-shi**
  **Hyogo 664-0016 (JP)**

(74) Representative: **Grünecker, Kinkeldey,**
**Stockmair & Schwanhäusser**
**Anwaltssozietät**
**Maximilianstrasse 58**
**80538 München (DE)**

(54) **Method of growing gallium nitride crystal**

(57) A method of growing a gallium nitride crystal, includes: a step of partially forming, on a ground substrate (U), a mask (M) inhibiting epitaxial growth of a gallium nitride crystal; and a step of epitaxially growing, while doping carbon, the gallium nitride crystal on the ground substrate (U) in which the mask (M) is formed. In the epitaxial growth, a first crystal region is grown from a periphery of the mask (M) toward inside. C-axis direction is reversed in the first crystal region relative to a second crystal region grown on a region where the mask (M) is not formed in the ground substrate (U). Therefore, a stable crystal grain boundary is produced at the boundary between the first and second regions, and a density of dislocations in the crystal is efficiently reduced.

FIG.7

## Description

BACKGROUND OF THE INVENTION

Field of the Invention

A gallium nitride based blue-violet laser is used for a large capacity optical disc of the next generation. In order to put the blue-violet laser to practical use, a gallium nitride substrate of high quality is required. The present invention relates to a method of growing a gallium nitride crystal for manufacturing a gallium nitride substrate of high quality.

Description of the Background Art

A gallium nitride (GaN) based semiconductor laser having a wavelength of 405 nm is expected to be employed as a blue-violet laser used in recording and reproducing data on/from a high-density optical disc. A blue-violet light emitting diode (LED) is produced by forming a thin film of GaN, InGaN or the like on a sapphire ($Al_2O_3$) substrate. Since sapphire and gallium nitride are significantly different in lattice constant, a high density of dislocation defects occur. In an LED of a low current density, defects are not increased and the LED has a long operating life, and a sapphire substrate of heterogeneous substrate having different chemical composition from gallium nitride serves enough as a ground substrate. However, it has been found that a sapphire substrate is not suitable for a semiconductor laser (laser diode; LD) of a high injection current density. Because of the high current density, defects are increased and rapid deterioration is invited. Unlike LEDs, a blue-violet laser employing a sapphire substrate has not been put to practical use.

There are no materials that are close enough to gallium nitride in the lattice constant. Recently, it has been found that a substrate on which a gallium nitride thin film is formed must itself be gallium nitride. In order to implement a blue-violet semiconductor laser, a gallium nitride substrate of a low dislocation density and of high quality is strongly requested.

However, it is very difficult to grow a gallium nitride crystal. Gallium nitride (GaN) does not melt when heated, and therefore a crystal growth method from a liquid phase to a solid phase cannot be employed. An attempt has been made to grow a gallium nitride crystal by a growth method from a gas phase in which gas is used as a material. In order to grow a crystal of a gallium nitride substrate of a large diameter and high quality having the size of practical level, various developments have been made.

The inventors of the present invention have developed and proposed a scheme in which a mask is applied on a heterogeneous ground substrate to thickly grow a gallium nitride crystal, and thereafter the heterogeneous ground substrate is removed to thereby obtain a thick gallium nitride free-standing crystal.

WO99/23693 proposes an invention, which has been made by the same inventors of the present invention, and which is directed to a method in which, on a GaAs ground substrate, a mask having stripe (parallel linear) openings or circular openings is formed, on which a gallium nitride crystal is thickly grown, and the GaAs ground substrate is removed to obtain a gallium nitride single free-standing crystal (substrate). The mask is a cover portion dominant mask in which a cover portion is great and holes (expose portions) are small. A crystal nucleus is formed only in each opening. As the thickness is increased, the crystal climbs on the cover portion, and it extends laterally and dislocations also extend laterally. The crystals laterally extending from adjacent openings collide and turn their growth direction upwardly. This significantly reduces dislocations. In this state, maintaining the flat plane (C-plane) upwardly, the crystal is grown.

This method is called as ELO (Epitaxial Lateral Overgrowth) method, as the crystal is grown laterally over the mask to thereby reduce dislocations. In a gallium nitride (GaN) free-standing film formed in this manner, dislocations are significantly reduced. A method is also proposed in which, using the GaN crystal as a new substrate, a GaN crystal is further grown through vapor phase deposition into a thick GaN crystal ingot, which is cut perpendicularly to the growth direction so that a plurality of GaN substrates (wafers) are manufactured. The vapor phase deposition growth of a gallium nitride crystal includes the MOCVD (Metal Organic Chemical Vapor Deposition) method, the MOC (Metal Organic Chloride) method, the HVPE (Hydride Vapor Phase Epitaxy) method, the sublimation method and the like. According to the invention of WO99/23693 by the present inventors, the HVPE method attains the fastest crystal growth rate and hence it is greatly advantageous, among others.

However, a gallium nitride crystal produced through the above-described method still has a significantly high density of dislocations and therefore is of low quality. An excellent device cannot be produced if its substrate, i.e., a gallium nitride substrate itself is not of high quality. In particular, a substrate for mass production is required to be of excellent quality, having a low density of dislocations over a wide area. As a method of reducing a dislocation density of a substrate itself for obtaining a gallium nitride substrate of high quality, the present inventors proposed the following scheme, which is disclosed in Japanese Patent Laying-Open No. 2001-102307.

In the dislocation reduction method, while a GaN crystal is thickly grown, occurring dislocation defects are gathered at a particular location so that dislocation defects in the other area is reduced.

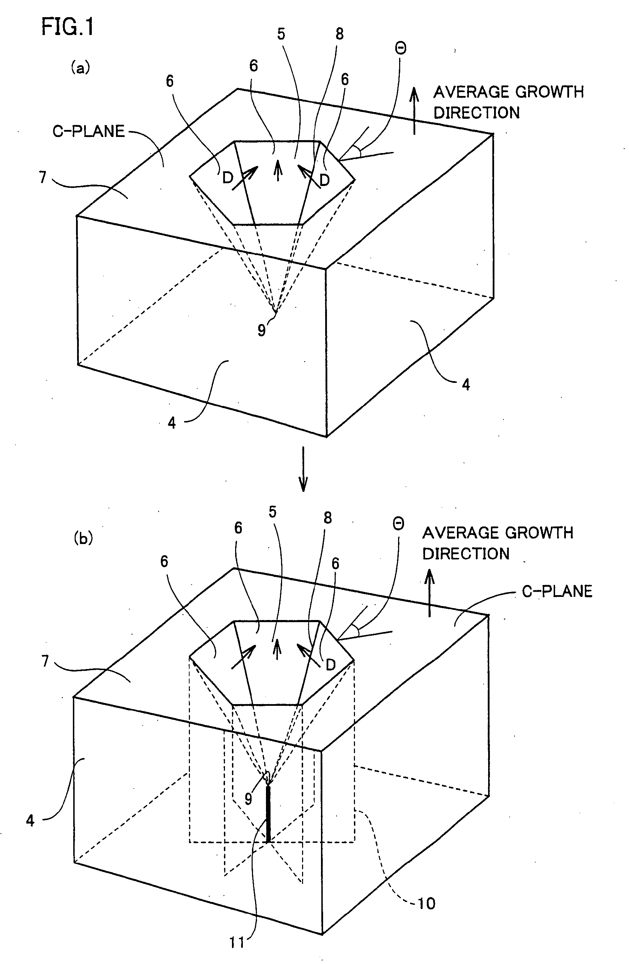

A three-dimensional facet structure, for example an inverted hexagonal pyramid pit (hole) constituted of facet planes is formed. A crystal is grown while the facet shape is constantly maintained and the pit is unburied. Figs. 1(a) and (b) show part of a crystal 4 in which an inverted hexagonal pyramid pit 5 is formed. The top plane of crystal 4 is not perfectly flat and pits 5 are provided in several locations. The flat top plane 7 is C-plane. Pit 5 may be an inverted hexagonal pyramid, or it may be an inverted dodecagonal pyramid. Pits 5 are adjacent to each other so that facets 6 form an angle of 120° between them. Adjacent facets 6, 6 join at a ridge 8. A pit bottom 9 where ridges 8 converge is a portion where the tips of faces are gathered.

The crystal growth occurs in the direction of a normal line of a plane (meaning a ray perpendicular to a plane, hereinafter the same applies). The average growth direction is upward. At top plane (C-plane) 7, the crystal growth occurs in an upward direction (c-axis direction). At facet 6, the crystal growth occurs in a diagonal direction. An angle of facet 6 relative to C-plane is specified as $\Theta$. The facet being unburied means that a growth rate u at top plane (C-plane) 7 and a growth rate v at a facet are not the same, and that anisotropy such as $v = u\cos\Theta$ is provided.

Dislocation D extends in parallel with the growth direction of the crystal. Dislocation D having been on facet 6 moves to ridge 8 as the crystal growth progresses. Since v < u and the growth rate at the facet is slower than at C-plane, dislocation D arriving at ridge 8 is fixed to ridge 8, then relatively descends along ridge 8 to converge at a pit bottom 9. As shown in Fig. 1(b), continuously from ridge 8, a planar dislocation gathering portion 10 is formed. Dislocations D having descended along ridge 8 form a linear dislocation gathering bundle 11 continuously from pit bottom 9. As dislocations having been on facet 6 are gathered at planar dislocation gathering portion 10 or linear dislocation gathering bundle 11, dislocations D are gradually eliminated from facet 6. Thus, a low density of dislocations at the facet portion is attained. Dislocations D at C-plane 7 are also attracted toward facet 6. If pits 5 are provided at a high density, dislocations D are swept under pit bottom 9 or ridge 8, whereby dislocations in the other area are reduced. By maintaining pit 5 unburied until the end of the growth, the dislocation reduction effect constantly continues.

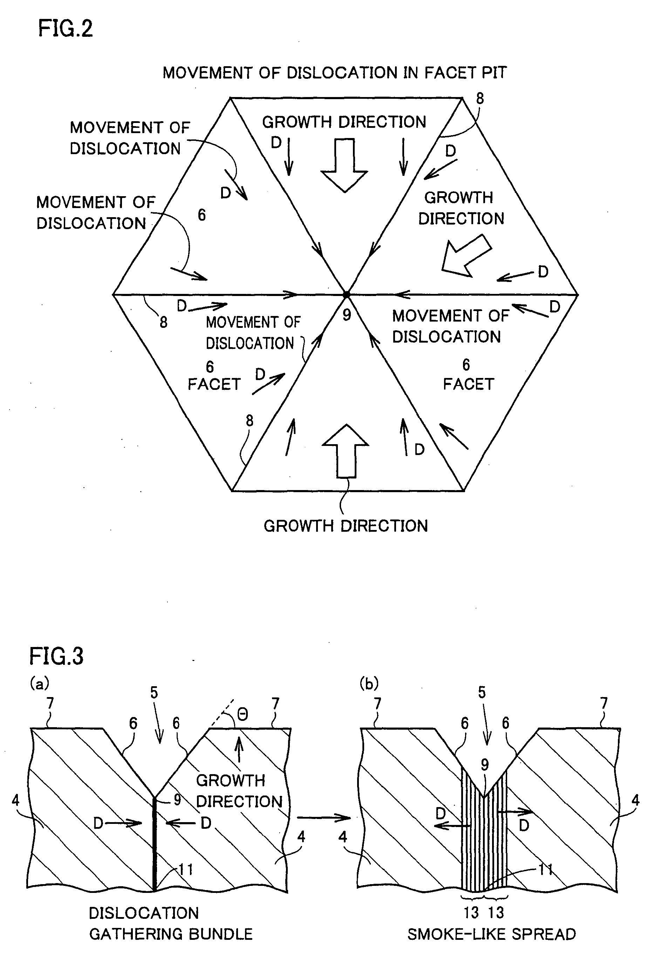

Fig. 2 is a pit plan view showing such dislocation reduction effect by facet growth. When facet 6 is maintained, the growth direction is the normal line direction, and dislocations D also extend in the normal direction. Fig. 2 shows that the direction of the dislocations and the growth direction are the same. Projecting on the facets in the plan view, the direction in which a dislocations D extend is the direction of the gradient of a facet, which arrives at ridge 8. Arriving at ridge 8, dislocations D move toward inside along ridge 8. "Move toward inside" means that it relatively descends along ridge 8. While dislocations D actually extend only upwardly, it relatively descend because v < u. Dislocations D form a planar defect 10 along ridge 8. Other dislocations D gather at a converge point 9 (pit bottom). Linear dislocation gathering bundle 11 continuous from pit bottom 9 is formed.

However, it has been found that this method in which facet growth is utilized involves the following problems (1) and (2).

(1) After the crystal is grown thicker and more dislocations D are gathered, dislocations D tend to be again dispersed and broadened in a smoke-like manner from the dislocation gathering bundle at the center of a pit constituted of facet planes. This is described referring to Fig. 3. Fig. 3 (a) is a longitudinal cross-sectional view of a facet pit, which shows that dislocations D are gathered at pit bottom 9 to form linear dislocation gathering bundle 11 (linear defects). Fig. 3(b) shows that the once gathered dislocations D are again dispersed and broadened in a smoke-like manner. Smoke-like broadened dislocations 13 indicates that dislocation gathering bundle 11 continuous from pit bottom 9 is poor in confining dislocations D.
(2) Linear dislocation gathering bundle 11 at the center of pit 5 constituted of facet planes is positioned accidentally. It is randomly distributed and cannot be determined in advance. That is, the position of dislocation gathering bundle 11 cannot be controlled.

Problem (2) is attributed to the fact that facet pit 5 is accidentally formed and that where to be formed cannot be determined. It is desirable that the position where pit 5 is formed can be determined in advance. As to Problem (1), it is desirable that a barrier or the like is formed, which is concrete and which does not release dislocations once gathered.

To solve such two problems, the present inventors made the following developments.

The present inventors considered that smoke-like broadened dislocations 13 as shown in Fig. 3(b) occurs because dislocations D gathered at bottom 9 of inverted hexagonal pyramid pit 5 are not eliminated but only reside there.

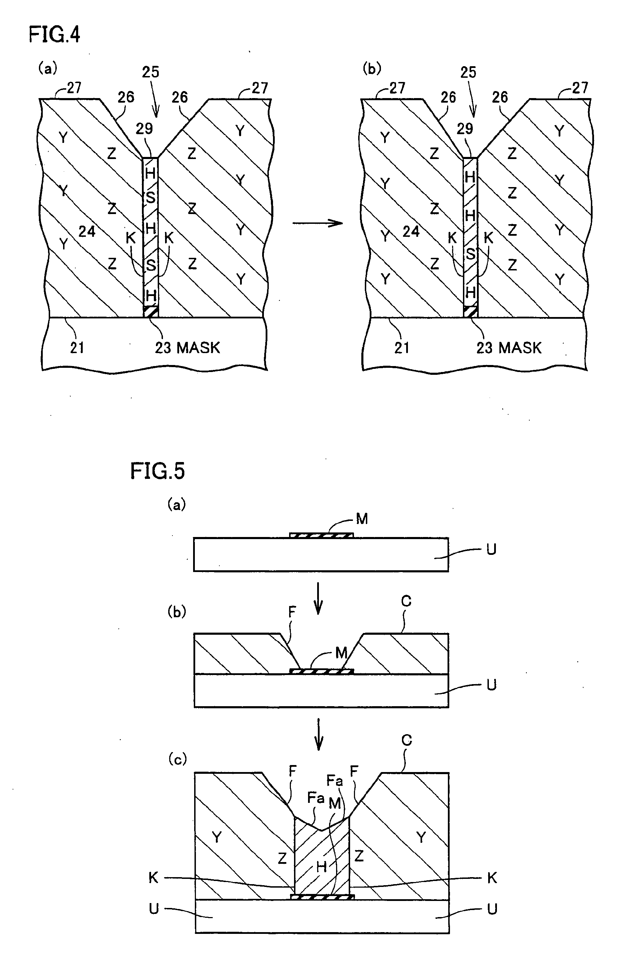

Then the inventors arrived at the idea of adding a dislocation eliminating/accumulating mechanism to the dislocation gathering portion. This is shown in Fig. 4(a) and (b). Isolated dot-like masks 23 having an effect of inhibiting epitaxial growth are applied on a ground substrate 21 so as to be regularly distributed. Growth occurs at the expose portion. At the center of an expose portion, growth in which C-plane is a top plane 27 occurs and leadingly proceeds. A crystal 24 is grown primarily at the expose portion.

However, growth hardly occurs on mask 23. Since growth proceeds at the expose portion, facets 26 the base of which is the mask end and facet pit 25 being the group of facets 26 are formed. The growth is continued until the end while facet pit 25 is unburied. Along facets 26, dislocations D are swept and arrive at pit bottom 29. Pit bottom 29 is positioned immediately over mask 23. Dislocations D converge at a portion over mask 23. The portion where dislocations converge is a crystal defect gathering region H. That is, in the grown GaN crystal, a first crystal region formed over a mask is crystal defect gathering region H. This crystal defect gathering region H is constituted of a crystal grain boundary K and a core S, i.e., region H = core S + crystal grain boundary K. By applying mask 23 on ground substrate 21, crystal defect gathering region H surrounded by crystal grain boundary K is produced as a dislocation D eliminating/ accumulating mechanism. That is, mask 23, crystal defect gathering region H (first crystal region), and pit bottom 29 align on one line in the vertical direction. Mask 23 determines the positions of crystal defect gathering region H (first crystal region) and pit 26. In the grown GaN crystal, second crystal regions grown on a plane region where the mask is not formed on the ground substrate region (that is, the expose portion), a portion under facet 26 is the portion grown at the facet, where crystal defects are reduced than in other portions. Therefore, it is referred to as a low crystal defect region portion Z. A portion under C-plane 27 on the expose portion is the portion grown while C-plane is maintained, and it is referred to as a C-plane growth region portion Y. As the second crystal regions are constituted of low crystal defect region portion Z and C-plane growth region portion Y, they are denoted by ZY in the following.

Dislocations of the GaN crystal converge at crystal defect gathering region H. Crystal defect gathering region H has a finite width, and moreover, surrounded by crystal grain boundary K. Dislocations D do not dispersed again from crystal defect gathering region H. Crystal grain boundary K has an effect of eliminating the dislocations. The inside of crystal grain boundary K is core S. Core S has an effect of accumulating and eliminating the dislocations. What is important is that the region that is constituted of crystal grain boundary K and core S where the dislocations converge is actively produced by mask. As the growth progresses, while the state transits from Fig. 4(a) to Fig. 4(b), the dislocations are not dispersed again since they are confined in crystal defect gathering region H. The same state is maintained endlessly. Thus, confinement of dislocations D is fully achieved, solving the problem of the dislocations dispersed again in a smoke-like manner.

Initially, the nature of crystal defect gathering region H that is a first crystal region was not clear. Crystal defect gathering region H is not univocally determined. In one case, it may be a polycrystal region P. In another case, it may be a single crystal region A in which a crystal axis is slightly tilted relative to crystal regions ZY (i.e., second crystal regions ZY, hereinafter the same applies) other than first crystal region. In still another case, it is a single crystal region J in which c-axis direction is reversed relative to second crystal regions ZY. It has been found that such diversity may depend on conditions for growth.

Optimally, crystal defect gathering region H being the first crystal region is single crystal region J in which [0001] direction (c-axis direction) is reversed relative to second crystal regions ZY. In this case, in crystal defect gathering region H, crystal orientation is reversed with respect to c-axis direction relative to second crystal regions ZY, and therefore clear crystal grain boundary K is formed around crystal defect gathering region H. Crystal grain boundary K has a strong effect of eliminating and accumulating dislocations. When crystal defect gathering region H is polycrystal region P, or single crystal region A in which crystal orientation is slightly different from that of second crystal regions ZY, crystal grain boundary K is not clearly formed and the effect of eliminating and accumulating dislocations is weak.

There are two types of single crystal regions that are second crystal regions ZY. The portion grown under a facet plane is the portion where crystal defects are particularly reduced, and referred to as low crystal defect region portion Z. The portion grown under C-plane is referred to as C-plane growth region portion Y. They are both single crystals having the same crystal orientation and have a low density of dislocations. However, they are different in electric characteristics. C-plane growth region portion Y has a high resistance, while low crystal defect region portion Z has a low resistance.

While low crystal defect region portion Z and C-plane growth region portion Y are each a single crystal in which [0001] direction (c-axis direction) is upward, single crystal region J in which c-axis is reversed is a single crystal in which [000-1] orientation (-c-axis direction) is upward. As the crystal orientation is reversed, crystal grain boundary K is stably produced between the boundary of H and Z. As crystal grain boundary K has the effect of eliminating and confining dislocations D, it is a useful characteristic that K is produced between H and Z. The inside and outside regions are clearly distinguished from each other at crystal grain boundary K.

The formation of region J (referred to as orientation reversed region J, hereinafter the same applies) in which c-axis direction ([0001] direction) is reversed relative to second crystal regions ZY as crystal defect gathering region H that is the first crystal region is most effective in reducing a dislocation density. It is noted that "c-axis direction is reversed" means that c-axis direction is different by 180°. Orientation reversed region J has the reversed polarity of c-axis direction of the crystal because of the reversed c-axis crystal orientation, and therefore it is also referred to as polarity reversed region J. That is, in the present specification, the orientation reversed region and the polarity reversed region are synonymous with each other. The orientation reversed region is the term directly expressing the crystal structure. On the other hand, the polarity reversed region is the term expressing the property and characteristic of the crystal, which is commonly often used.

When crystal defect gathering region H is polarity reversed region J, crystal defect gathering region H becomes a recess since the crystal growth rate of polarity reversed region J is low. It can be positioned at the pit bottom or a trough. Accordingly, crystal defect gathering region H can stably be present at the pit bottom of the inverted hexagonal pyramid where dislocations are gathered.

At crystal grain boundary K around crystal defect gathering region H, dislocations are efficiently eliminated and the smoke-like broadened dislocations do not occur. A gallium nitride crystal of a low defect density in which the defect dislocations are confined in crystal defect gathering region H and in the very close vicinity thereof can be obtained.

The region where crystal defect gathering region H should occur can be fixed to an arbitrary position. This crystal defect gathering region H does not randomly accidentally occur and present, but instead it can be formed at a predetermined position. Thus, an excellent gallium nitride crystal can be produced, for example in which crystal defect gathering regions H are aligned regularly.

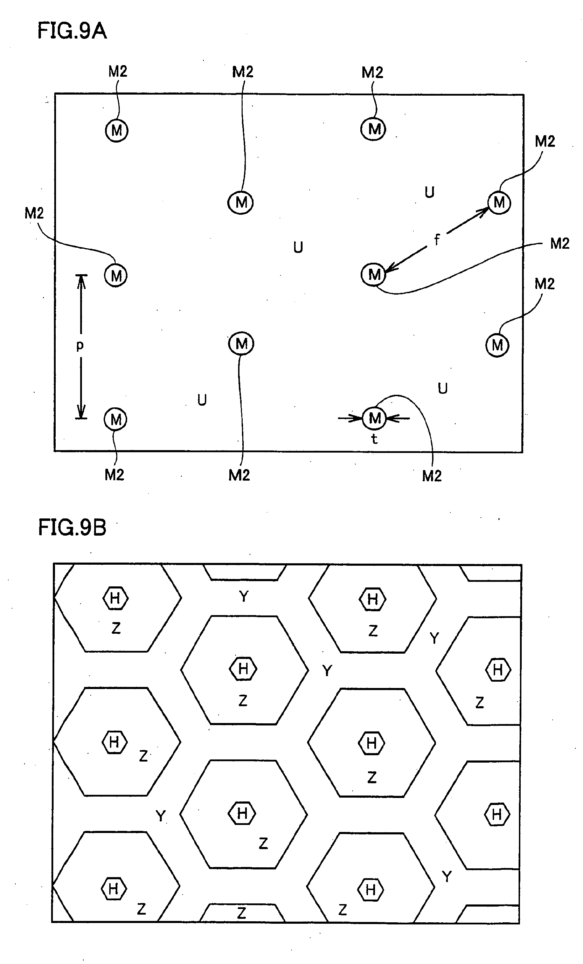

There may be various types as to the shape of crystal defect gathering region H. For example, it can be a dot-like isolated closed region. Japanese Patent Laying-Open No. 2003-165799 proposes a gallium nitride crystal having such an arrangement of crystal defect gathering region H. Fig. 9A is a plan view showing one example of the dot mask. Masks M of isolated dots regularly distributed on ground substrate U are formed. Over the expose portion, a crystal of a low defect density is formed. In the obtained crystal, the portion over each dot mask M is crystal defect gathering region H. A facet pit having this crystal defect gathering region H as a bottom is formed. The portion under the facet is low crystal defect region portion Z, and the portion under C-plane outside the facet is C-plane growth region portion Y.

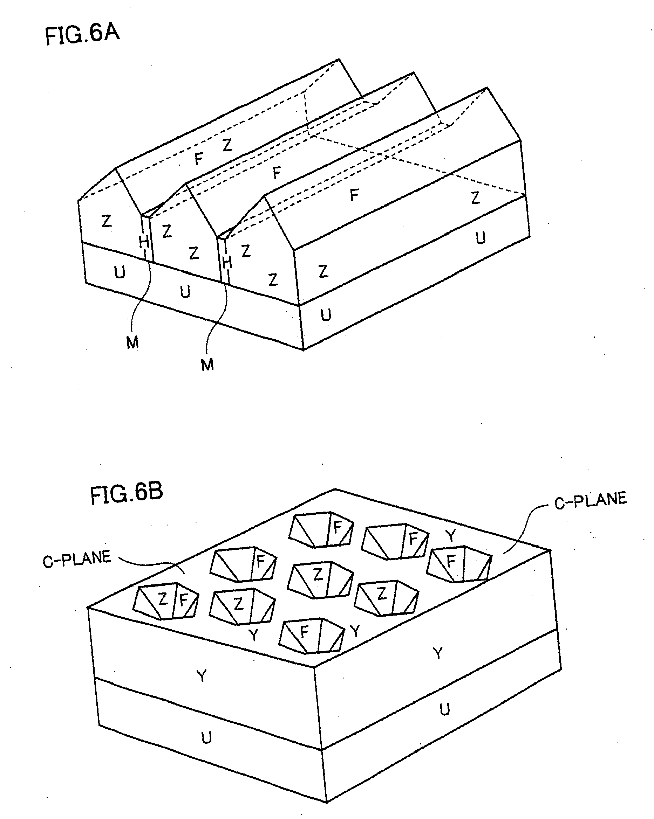

Fig. 6B is a perspective view of a crystal where GaN is grown over ground substrate U provided with dot masks. While C-plane growth portion Y is great, there are a large number of pyramid pits constituted of facets F. Over a dot mask, a pit is formed. Fig. 9B shows a planar structure, in which the ground substrate is removed from the GaN crystal grown over the dot mask, and the crystal is then polished and grinded to be a flat substrate (wafer). The portion over the mask becomes crystal defect gathering region H, around which low crystal defect portion Z and C-plane growth region portion Y surround to form a concentric structure.

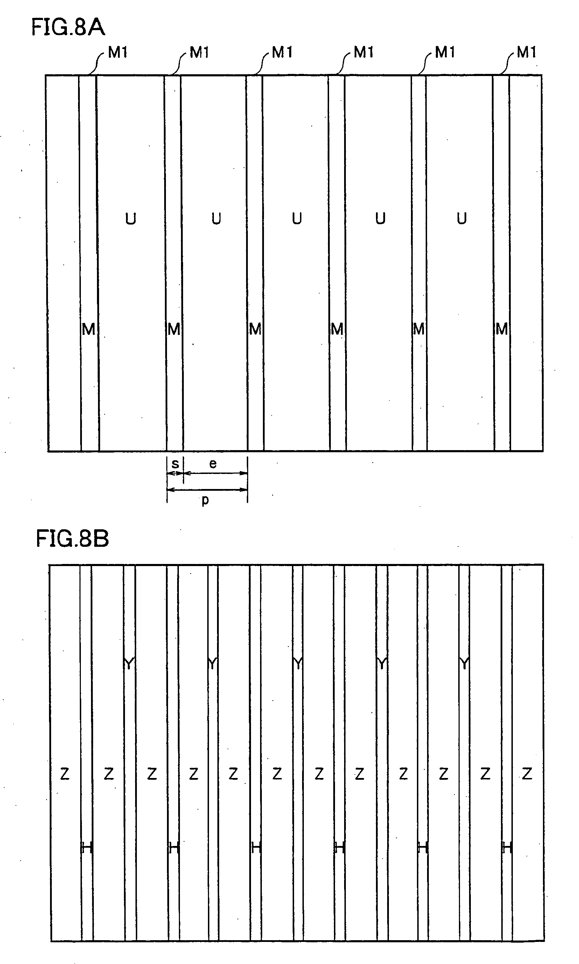

Alternatively, crystal defect gathering region H can be formed to be parallel strips (stripes). Japanese Patent Laying-Open No. 2003-183100 proposes a gallium nitride crystal having crystal defect gathering region H of such a stripe type. Stripe masks are shown in Fig. 8A. On ground substrate U, parallel and linear masks (width s) are regularly (pitch p) formed in a large number. Fig. 6A shows a state in which gallium nitride is grown thereon. A crest formed of low crystal defect region portion Z is formed on an expose portion. A slope of the crest is facet F. Over mask M, a V-shaped groove formed of crystal defect gathering region H is formed. Fig. 8B shows a planar structure of a wafer, obtained by growing a gallium nitride crystal on the ground substrate on which the stripe masks are formed, then removing the crystal from the ground substrate, to be grinded and polished. It has a parallel structure of HZYZHZYZ... .

Fig. 5 is a drawing for describing the facet growth method using stripe masks. Masks M (stripe masks) extending in parallel with each other are applied on ground substrate U (Fig. 5(a)). Masks M extend perpendicularly to the surface of the drawing. GaN is grown through vapor phase deposition on ground substrate U and masks M. While a crystal nucleus is produced and grown on the ground substrate, a crystal nucleus is not formed on a mask and therefore crystal growth does not occur. In the portion other than a mask (expose portion), a GaN crystal is formed in c-axis direction (Fig. 5(b)). The top plane of the crystal is C-plane. Initially a crystal is not formed over mask M, and therefore a space is formed. Crystals from both sides approach the edge of the mask: The tilted plane of a crystal extending upwardly from the end of the mask is facet F.

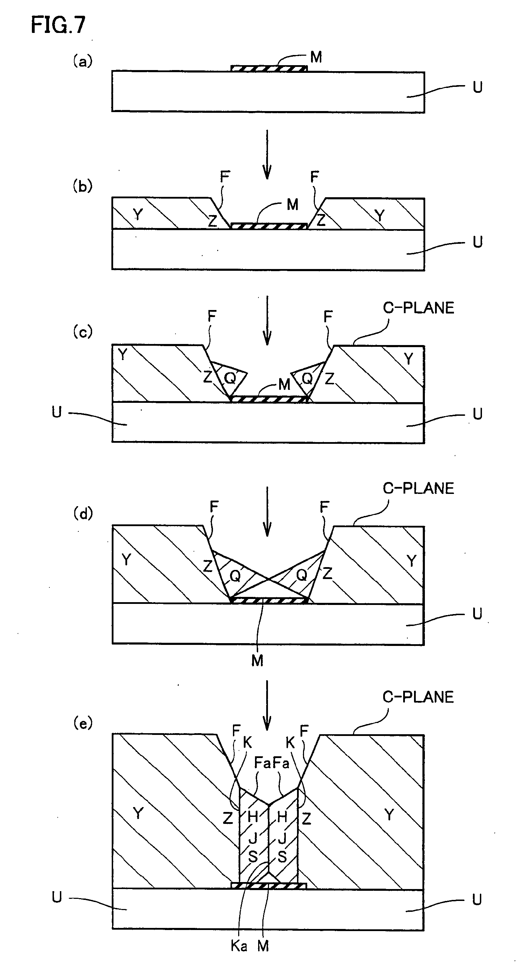

As the growth progresses further, the crystal climbs also on mask M (Fig. 5(c)). This portion is a recess since the growth is delayed than in other portions. The crystal on mask M is crystal defect gathering region H in which c-axis direction ([0001] direction) is reversed relative to second crystal regions ZY. Another facets Fa, Fa with a smaller tilt are present thereon. They are identical to the tilt of the top plane of nails Q shown in Fig. 7 (c) and (d). Grown over the expose portion and under facet F is low crystal defect region portion Z. Grown over the expose portion and under C-plane (top plane) is C-plane growth region portion Y. The boundary plane between crystal defect gathering region H and low crystal defect region portion Z is crystal grain boundary K: The boundary line between differently tilted facet F and facet Fa is on grain boundary K.

Since there are a plurality of parallel masks M, crystal defect gathering regions H form parallel troughs. A portion between masks is low crystal defect region portion Z or C-plane growth region portion Y. Z and Y are parallel crests. That is, when the stripe masks are used, the crystal has a structure in which parallel crests and troughs are repeated. When there is no C-plane growth region portion Y, a sharp crest appears. When there is C-plane growth region portion Y, the portion becomes a flat crest.

A substantially similar manner is shown also when masks M are isolated dot masks. In this case, isolated pits each constituted of facets F around mask M is formed. The portion on the expose portion and under facet F is low crystal defect region portion Z, and the portion on the expose portion and under C-plane is C-plane growth region portion Y. It is noted that X and Y are single crystal regions having a low density of dislocations, with the same crystal orientation. That is, a crystal has a structure in which a large number of isolated pits are aligned on C-plane. While the states are similarly shown in the cross-sectional views, in the case of the dot masks, crystal defect gathering region H is an isolated closed region. Facet F often has plane orientation of {11-22}, {1-101} or the like. It can be said that mask M is the seed of crystal defect gathering region H.

The portion over the mask is crystal defect gathering region H. Crystal defect gathering region H is polycrystal region P, single crystal region A in which crystal orientation is displaced relative to second crystal regions ZY, or an orientation reversed single crystal region (polarity reversed region J) in which c-axis direction ([0001] direction) is reversed relative to second crystal regions ZY. There is also a case where crystal defect gathering region H is not formed over the mask (O). That is, there are four types of crystal region grown over the mask, which are O, A, P and J.

When crystal defect gathering region H that is the first crystal region is a single crystal region in which c-axis direction is reversed relative to second crystal regions ZY, Ga plane and N plane of crystal defect gathering region H are opposite to those of second crystal regions ZY. Accordingly, the orientation reversed region in a GaN crystal is also commonly referred to as a polarity reversed region.

The boundary between crystal defect gathering region H and low crystal defect region portion Z is crystal grain boundary K. The top of crystal defect gathering region H is facet Fa that is more moderately tilted.

By forming initially the seed (mask) on the ground substrate, the position where crystal defect gathering region H (first crystal region) is formed is determined. Correspondingly, the positions where low crystal defect region portion Z and C-plane growth region portion Y (second crystal regions ZY) are formed are also determined. This means that the aforementioned drawback that the position of crystal defect gathering region H cannot be determined has been overcome.

Moreover, since orientation reversed crystal defect gathering region H has clear crystal grain boundary K around it, dislocations once converged do not dispersed again in a smoke-like manner. By forming the mask on the ground substrate in advance, it becomes possible to control the position where crystal defect gathering region H is formed.

While the positioning control of H, Z and Y structures can clearly be achieved by the mask position, it has been found that there are cases where crystal defect gathering region H is capable of forming clear crystal grain boundary K and where it is not. While crystal defect gathering region H being the first crystal region is formed over the mask, it is not always orientation reversed region (polarity reversed region) J in which c-axis is rotated by 180° relative to second crystal regions ZY. Instead, it may be polycrystal region P. It may be single crystal region A in which crystal orientation is different from that of second crystal regions ZY. Crystal defect gathering region H may not be formed. Accordingly, there are four types of the crystal region grown over the mask, which are O, A, P and J.

When crystal defect gathering region H over the mask is polycrystal region P, there is also a partial crystal of which orientation is similar to low crystal defect region portion Z adjacent thereto. Therefore, there are no discrepancy in the crystal structure between them, and hence crystal grain boundary K does not clearly appear. Also, when crystal defect gathering region H. being the first crystal region is single crystal region A in which c-axis direction is slightly tilted relative to second crystal regions ZY, the crystal structures are partially similar and crystal grain boundary K is not clear. Crystal grain boundary K clearly appears when crystal defect gathering region H is polarity reversed region J in which c-axis direction is reversed by 180° relative to second crystal regions ZY.

When polarity reversed region J is formed, in any portion crystal defect gathering region H and surrounding low crystal defect region portion Z are greatly different in the lattice structure: Thus, the boundary becomes crystal grain boundary K. Without crystal grain boundary K, the effect of capturing, eliminating and accumulating dislocations is weak. Therefore, it is strongly desired that crystal defect gathering region H in which crystal orientation is constantly reversed is formed over the mask as the first crystal region. Japanese Patent Laying-Open No. 2006-66496 discloses crystal growth in which a crystal defect gathering region H, in which polarity is different from that of other crystal region, is formed over a mask. However, it does not disclose a method of constantly forming a polarity reversed region as crystal defect region H. An object of the present invention is to provide a method of ensuring formation of crystal defect gathering region H formed over the mask as polarity reversed region J in which c-axis direction ([0001] direction) is reversed by 180° relative to second crystal regions ZY.

SUMMARY OF THE INVENTION

It is optimum that polarity reversed region J is formed as crystal defect gathering region H being the first crystal region formed over the mask. An object of the present invention is to ensure formation of polarity reversed region J over the mask. A close observation was carried out as to the manner of crystal growth when polarity reversed region J in which c-axis direction ([0001] direction) was reversed by 180° relative to second crystal regions ZY was formed over the mask. It was found that crystal region (polarity reversed region J) in which c-axis direction was reversed was formed over the mask through the following processes. Fig. 7 shows such processes.

1) A seed (mask) M using a material inhibiting epitaxial growth is formed at the position where crystal defect gathering region H is to be formed on ground substrate U. A seed means the seed for crystal defect gathering region H, and it is synonymously used as mask M. Fig. 7(a) shows this state. While only one stripe mask M is shown, actually a plurality of masks M are formed in parallel to one another.

2) On ground substrate U, a gallium nitride crystal is grown through vapor phase deposition. Since crystal nucleus is easily formed on ground substrate U (expose portion) and not formed over the mask (cover portion), the crystal growth is initiated only at the expose portion. The crystal orientation in which C-plane is the top plane is attained. The progress of the growth of the gallium nitride crystal is stopped at the end (periphery) of the seed (mask). Initially, the crystal does not climb on seed M. It does not climb on seed M and does not grow laterally. A tilted plane is generated, which extends diagonally upward from the peripheral of the seed (mask) to the expose portion side (Fig. 7(b)). This is one of facets F that is not C-plane. Often, this facet F is {11-22} plane. When the stripe mask is seed M, facet F extends in the direction perpendicular to the surface of the drawing. When it is the dot mask (isolated dot), it is an opening (pit). Since the manner is similar between the stripe and dot masks, herein the case of the stripe mask is described.

3) From an end (an end on the mask periphery side) of a tilted plane of a facet of the gallium nitride crystal of which growth is stopped at the end (periphery) of the seed (mask), a nail-like fine crystal is produced and extends in the horizontal direction. In the nail-like fine crystal, c-axis direction ([0001] direction) is reversed by 180° relative to low crystal defect region portion Z, which is the portion adjacent to nail Q. Fig. 7(c) shows this state. Nail Q has a plane tilted more moderately than facet F, and has underneath another tilted plane. It was found that crystal orientation of nail Q is different from the adjacent portion (low crystal defect region portion Z) by 180°. That is, nail Q is the polarity reversed region.

4) As the crystal grows, the number of nails Q in which crystal orientation is reversed and which are formed on facets increases. Each of nails Q is enlarged and becomes a long column on each side of a groove. From opposing sides, nails Q extend so as to cover the mask.

5) Nails Q in which crystal orientation is reversed each have facet Fa having a smaller angle than facet F has, on the upper side. Upper facet Fa is a facet with a small tilt angle, which has plane orientation such as {11-2-6}, {11-2-5} or the like. The lower facet is a more greatly tilted plane.

6) Nails Q are enlarged in the vertical and horizontal directions, and tips of nails Q collide and contact with each other over the mask. Nails Q are integrated to form a bridge portion as shown in Fig. 7(d). After the bridge portion is formed, a crystal in which orientation is similarly reversed is grown on nails Q, Q. A crystal is also formed in the gap below, in which orientation is also similarly reversed. This portion immediately over the mask is not formed by the crystal that climbs on the mask and extends laterally, but instead, it is formed by the crystal grown downwardly from the bridge portion where the nails are integrated. The growth direction is opposite to the crystal orientation of second crystal regions ZY.

7) The collided portions are grown thickly, maintaining lattice mismatched boundary Ka between them. This boundary Ka is different from crystal grain boundary K between nail Q and low defect single crystal regions Z on both sides. Polarity reversed nail Q becomes crystal defect gathering region H.

8) By thickly growing the crystal (Fig. 7(e)), dislocations in the gallium nitride crystal is gathered into crystal defect gathering region H over the mask. The gathered dislocations are partially eliminated and reduced at crystal grain boundary K that is the boundary between crystal defect gathering region H (nail Q) and low defect single crystal regions Z, or at core S. Nail Q extends upwardly, whereby crystal defect gathering region H is formed. The dislocations not being eliminated are captured and accumulated inside crystal grain boundary K and core S. Under the facet plane, dislocations are reduced and thus this portion becomes low defect single crystal regions Z.

Through such processes, crystal defect gathering region H as the orientation reversed region (polarity reversed region) is formed. Therefore, in order for the portion over the mask to be a c-axis reversed portion, it is necessary to form nail Q as shown in Fig. 7(c) on the entire plane of facet F (for example {11-22} plane). Also, it is necessary to stably form on the entire plane. If nail Q cannot stably be formed on facet F, crystal defect gathering region H over the mask cannot become the desired orientation reversed region. In this case, dislocations in the surrounding region (second crystal region) cannot be attracted and eliminated. The dislocations will be spread and low defect single crystal region portion Z will not be formed.

When the mask is simply formed on the ground substrate and a crystal is grown through vapor phase deposition, the portion over the mask will not successfully become an orientation reversed region. It is not easy to stably form nails Q in which crystal orientation is reversed on the entire plane of the facet extending diagonally from the mask edge.

The present invention is directed to reduction of dislocations by facet growth, which can be called as the facet growth method. It is clearly different from known ELO (Epitaxial Lateral Overgrowth) method, which is a scheme of reducing dislocations by using a mask. Although it is clearly different, sometimes the scheme of the present invention is confused with the ELO method because it is a scheme in which a mask is used to reduce dislocations. In order to avoid such confusion, some of the differences are described herein.

(a) In the ELO method, the cover portion area is far greater than the expose portion area (cover portion > expose portion). It can be recognized that a mask has openings at several portions. In the facet growth method according to the present invention, the expose portion is great and the cover portion is small (cover portion < expose portion). It can be recognized that the ground substrate is provided with only a few masks.

(b) They are clearly different in the presence of an orientation reversed region (polarity reversed region) of a crystal at the end of the mask. In the ELO method, the crystals produced at the expose portion maintains the orientation and climbs on the cover portion. That is, the crystal orientation is maintained. It is in the same crystal orientation. For example, when {11-22} facet is present at the mask end, the crystal climbs on the cover portion while the plane and the tilt are maintained. Over the mask also, the growth is continued while {11-22} plane is maintained. Therefore, the orientation reversion (polarity reversion) at the boundary of the mask does not occur. In the facet growth method according to the present invention, the crystal produced at the expose portion does not climb on the mask as it is. Instead, nail crystal Q is produced in the middle of facet distanced from the mask, which therefore is not continuous with the expose portion crystal.

(c) In the ELO method, the crystal growth direction for reducing dislocations is the lateral direction. By allowing a crystal to grow horizontally and laterally to the mask, threading dislocations in the portion laterally grown are reduced. However, in the facet growth method according to the present invention, the direction of crystal growth is the thickness direction. By allowing a crystal to grow in the thickness direction, dislocations are gathered into crystal defect gathering region H and reduced. They are different in the crystal growth direction.

(d) As to the process of reducing dislocations, according to the ELO method, a low density of dislocations is attained over the mask. A defect region of a high dislocation density is formed at the expose portion. In contrast, according to the facet growth method, a single crystal of excellent quality with a low dislocation density is formed at the expose portion. A region with many defects and with a high dislocation density is formed over the mask. The ELO method and the facet growth method are totally opposite as to at which portion, i.e., at the cover portion or at the expose portion, the low dislocation density region and the high dislocation density region are formed.

In the present invention, mask inhibiting epitaxial growth is partially formed on the ground substrate, to produce a ground substrate surface where an expose portion and a cover portion are both present. While supplying a carbon material in addition to a Ga material and a nitrogen material gas, a gallium nitride crystal is grown through vapor phase deposition on the ground substrate.

Polarity reversed region (orientation reversed region) is formed on the mask. The essence of the present invention is to ensure, by adding carbon, crystal defect gathering region H formed on the mask to be polarity reversed region J. The vapor phase deposition growth of a gallium nitride crystal has been the buffer layer formation and the epitaxial growth. Between them, the present invention adds a process of polarity reversed region formation by addition of carbon. That is, the growth is constituted of three stages of the buffer layer formation, the polarity reversed region formation by carbon addition, and the epitaxial growth.

As the ground substrate, a sapphire (0001) single crystal substrate (a sapphire single crystal substrate in which the surface on which a gallium nitride crystal is grown is (0001) plane), a Si (111) single crystal substrate (a Si single crystal substrate in which the surface on which a gallium nitride crystal is grown is (111) plane), a SiC (0001) single crystal substrate (a SiC single crystal substrate in which the surface on which a gallium nitride crystal is grown is (0001) plane), a GaN single crystal substrate, a GaAs (111) A-plain single crystal substrate (a GaAs single crystal substrate in which the surface on which a gallium nitride crystal grown is (111) A-plane) or the like can be employed. A complex substrate (also referred to as a template) in which a GaN thin film is grown on a sapphire substrate can also be employed as the ground substrate.

A mask is formed on a ground substrate (Fig. 7(a)). A mask material is $SiO_2$ Pt, W, $Si_3N_4$ or the like. The thickness is about 30nm - 300nm. An exemplary mask pattern may be the stripe type (M1) in which a plurality of lines parallel with each other are aligned with a constant pitch (Fig. 8A). Alternatively, it may be the dot type (M2) in which isolated dots are regularly dispersed (Fig. 9A). Application of the mask forms the cover portion and the expose portion on the ground substrate surface. Preferably the cover portion is small and the expose portion is great.

On the ground substrate provided with the mask, a gallium nitride crystal is grown at a low temperature to form a thin buffer layer of about 30 nm - 200 nm. The buffer layer forming temperature is expressed as Tb. A low temperature such as Tb = 400 C° - 600 C° is preferable. The buffer layer has the effect of relaxing the stress of the ground substrate and the gallium nitride. A thin buffer layer is formed at the expose portion. There is no crystals over the cover portion yet, and therefore a buffer layer is not formed at the expose portion.

The essence of the present invention lies in the carbon doping growth that follows, for producing a polarity reversed region (orientation reversed region). Besides a Ga material and a nitrogen material, a carbon material is added so that a GaN crystal is grown on the ground substrate and the buffer layer. A crystal is not produced at the cover portion while the crystal growth progresses at the expose portion. The portion in contact with the cover portion (mask) becomes facet F (Fig. 7(b)).

The carbon doping produces nail Q at the middle of facet F rising from the end of the cover portion (Fig. 7(c)). Nail Q has its c-axis direction ([0001] direction) 180° reversed relative to a single crystal of the adjacent portion (low crystal defect region portion Z). That is, nail Q has its c-axis direction 180° reversed relative to second crystal regions ZY. Nails Q from opposing sides extend and integrated (Fig. 7(d)). Crystal grows further on nail Q, whereby nail Q is enlarged. This accumulates and crystal is also produced over the cover portion. Since the crystal grown over the cover portion is what has been formed on nail Q, its c-axis direction is different from that of second crystal regions ZY by 180°. That is, by the growth of nail Q produced over the cover portion, the polarity reversed region (orientation reversed region J) is grown. This polarity reversed region J extends upwardly over the cover portion, while substantially maintaining the cross sectional area of the cover portion (slightly narrower than the width of the cover portion) (Fig. 7(e)). This polarity reversed region J is crystal defect gathering region H that attracts dislocations from crystals of the surrounding region (i.e., second crystal regions ZY) and allows the dislocations to converge.

In the HVPE method, the Ga material is a Ga melt. GaCl is synthesized by HCl, and reacted with $NH_3$. The present invention ensures formation of the polarity reversed region (orientation reversed region) by adding carbon. Exemplary carbon materials are hydrocarbon gas and carbon solid. The HVPE method is normally conducted at the normal pressure (1 atm = 0.1 MPa). Initial conditions for forming the polarity reversed region is as follows. When the material is hydrocarbon gas, the partial pressure of hydrocarbon gas is preferably $1 \times 10^{-4}$ atm (10 Pa) - $5 \times 10^{-2}$ atm (5 kPa). Growth temperature Tj is preferably 900 °C - 1100 °C, and particularly preferably 990 °C - 1050 °C. The growth rate is preferably 50 $\mu$m/h- 100 $\mu$m/h.

As dislocations converge to the portion over the mask, this portion is referred to as crystal defect gathering region H. Crystal defect gathering region H is one of the three of polycrystal region P, single crystal region A in which a crystal axis is tilted relative to other regions (note that c-axis direction ([0001] direction) is not reversed), and single crystal region (polarity reversed region) J in which c-axis direction is reversed relative to other regions. In some cases crystal defect gathering region H is not formed (O).

Particularly, it is one of the features of the present invention that the first crystal region grown over the mask is polarity reversed region J. Crystal defect gathering region H pulls out dislocations from crystals of other regions grown over the adjacent expose portion and under the facet, and confines them in crystal defect gathering region H: The crystals grown over the expose portion and under the facet become single crystal Z with a low dislocation density. This effect is greater in order of:

Not produced O < single crystal region A in which a crystal axis is tilted < polycrystal region P < polarity reversed region J.

In the present invention, conditions for causing crystal defect gathering region H being the first crystal region to be polarity reversed region J have been sought for, and obtained. The present invention has enabled to produce polarity reversed region J always over the mask.

Which of the three, i.e., single crystal region A in which a crystal axis is tilted, polycrystal region P, and polarity reversed region J, first crystal region (crystal defect gathering region H) over the mask is can be determined by cathode luminescence (CL). It can also be known by fluorescent microscope observation. GaN crystals are uniformly transparent and therefore cannot be determined by the naked eye.

Epitaxial growth for the following thick film production is performed. The thick film growth time may range from several tens of hours, several hundreds of hours, and several thousands of hours, depending on the thickness of the target crystal. It is noted that the thick film producing epitaxial growth temperature is identified as a second growth temperature Te. Thick film producing epitaxial growth temperature Te is preferably Te = 990 °C - 1200 °C, and particularly preferably Te = 1000 °C - 1200 °C.

There has been a strong demand for an excellent gallium nitride substrate with few crystal defects. The facet growth method is promising, in which: a mask is formed on a ground substrate; a crystal is grown while maintaining the facet to form defect gathering region H being a first crystal region over the mask; and defects are gathered at defect gathering region H to thereby reduce dislocations in a second crystal region over an expose portion. Polarity reversed region J is most suitable for crystal defect gathering region H (first crystal region). It has been found that, in order to stably grow polarity reversed region J in which c-axis direction ([0001] direction) is reversed relative to second crystal region, the crystal growth conditions of the initial stage of growth of crystal defect gathering region H are important.

If the initial crystal growth conditions are not successfully met, crystal defect gathering region H grown over the mask does not become polarity reversed region J, and instead becomes polycrystal region P or single crystal region A in which a crystal axis is tilted (note that c-axis direction ([0001] direction) is not reversed). With the polycrystal region or the single crystal region in which a crystal axis is tilted, the effect of attracting dislocations from adjacent regions thereto to thereby reduce dislocations in the adjacent regions is insufficient. Accordingly, it is required that crystal defect gathering region H over the mask be polarity reversed region J.

It is noted that production of nail Q is important, in which 3), 4), 5) and 6) in the above-described process correspond to the initial stage of polarity reversed region J (nail Q) formation. In the present invention, it has been found that, in order for nail Q and polarity reversed region J continuing therefrom to be always produced, light doping of carbon at the initial growth stage is advantageous.

The initial crystal growth by carbon doping for forming the nail and the polarity reversed region is about 0.5 hours - 2 hours. Crystal defect gathering region H being polarity reversed region J is formed over the mask, and low defect single crystal region Z is formed over the expose portion. In some cases C-plane growth region portion Y is formed at the center of the expose portion. In some cases it is not present.

According to the present invention, by adding carbon, the polarity reversed region can surely be formed. Stable polarity reversed region J as the first crystal region is produced over the mask to further reduce dislocations in low defect region portion Z in the second crystal region, whereby a gallium nitride crystal of high quality can be grown.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a perspective view of a pit portion, for showing that, in the facet growth method proposed by the present inventors in WO99/23693, when growth is allowed without burying a hexagonal pyramid pit constituted of facet planes, dislocations extend in the facet normal line direction and gather at a boundary as the growth progresses, to further converge at a bottom of the pit along the boundary. Fig. 1(a) shows an initial stage of the growth and Fig. 1(b) shows a progressed stage of the growth.

Fig. 2 is a plan view of a pit portion, for showing that, in the facet growth method proposed by the present inventors in WO99/23693, when growth is allowed without burying a hexagonal pyramid pit constituted of facet planes, dislocations extend in the facet normal line direction and gather at a boundary as the growth progresses, to further converge at a bottom of the pit along the boundary. As the growth progresses at the facet in the normal line direction, dislocations also progress in that direction.

Fig. 3 is a cross-sectional view of a facet pit portion, for showing that, in the facet growth method proposed by the present inventors in WO99/23693, a bundle of dislocations once gathered at the bottom of the pit again spreads in a smoke-like manner. Fig. 3(a) shows a state where dislocations are once gathered at the pit bottom to form a dislocation gathered bundle, and Fig. 3 (b) shows a manner of the dislocations being separated from the pit bottom and spread in a smoke-like manner.

Fig. 4 is a longitudinal cross-sectional view of a pit and a V-shaped groove, for showing that, in the facet growth method using a mask proposed by the present inventors in Japanese Patent Laying-Open No. 2001-102307 and Japanese Patent Laying-Open No. 2003-165799, a crystal defect gathering region H having an effect of confining dislocations is produced over the mask and that dislocations once captured will not be dispersed and the growth is continued as it is. Fig. 4(a) shows a manner in which dislocations converge to defect gathering region H over the mask by the facet growth, and Fig. 4(b) shows a manner in which the dislocations are confined in defect gathering region H even when the facet growth further progresses.

Fig. 5 is a longitudinal cross-sectional view showing the facet growth method in which a mask is applied on a ground substrate and a gallium nitride crystal is grown thereon. Fig. 5(a) shows a state where the mask is formed on the ground substrate.

Fig. 5(b) shows a manner in which, when the gallium nitride crystal is grown, the crystal is grown only at the expose portion and no crystal growth occurs over the mask, and a facet diagonally extending from a mask end occurs. Fig. 5(c) shows a manner in which, as the crystal growth further progresses, the crystal grows also over the mask to form two-stages of facets.

Fig. 6A is a perspective view showing a gallium nitride crystal grown through the facet growth method on the ground substrate to which stripe masks are applied.

Fig. 6B is a perspective view showing a gallium nitride crystal grown through the facet growth method on the ground substrate to which dot masks are applied.

Fig. 7 is a longitudinal cross-sectional view related to the description of conditions for crystal defect gathering region H to be a polarity reversed region, when crystal defect gathering region H is formed over the mask at the initial stage of the growth. Fig. 7(a) shows a state in which the mask is provided on the ground substrate. Fig. 7(b) shows a manner in which, in the vapor phase deposition growth of the gallium nitride crystal, crystal growth occurs at the expose portion and the crystal growth does not occur over the mask, and facets of which ends are the mask are produced. Fig. 7(c) shows a state where nails Q are produced at the facets. Fig. 7(d) shows a state where the nails are integrated over the mask. Fig. 7(e) shows a manner in which crystal having the same crystal orientation as the nails is grown over the nails.

Fig. 8A is a plan view showing a substrate in which masks being parallel with each other are formed with a constant pitch p on a ground substrate.

Fig. 8B is a plan view showing a CL image of a wafer obtained by growing a crystal on the substrate shown in Fig. 8A through the facet growth method, separating the grown crystal from the ground substrate, subjecting it to polishing and grinding to be a flat plate.

Fig. 9A is a plan view showing a substrate in which, relative to an arbitrary specified isolated dot-like mask, a nearest isolated dot-like mask is formed on a ground substrate with a constant pitch p so as to attain sixfold symmetry to the specified mask.

Fig. 9B is a plan view showing a CL image of a wafer obtained by growing a crystal on the substrate shown in Fig. 9A through the facet growth method, separating the grown crystal from the ground substrate, subjecting it to polishing and grinding to be a flat plate.

DESCRIPTION OF THE PREFERRED EMBODIMENTS

As a method of growing a gallium nitride crystal, the HVPE method, the MOCVD method, the MOC method, the sublimation method and the like may be employed. In the present invention, the preferable manner is to add a carbon material in the HVPE method to form a polarity reversed region over a mask. While carbon is included in the material in the MOCVD method and the MOC method, it is not clear whether such carbon always forms a polarity reversed region over the mask.

Accordingly, in the Examples, what is grown through the HVPE (Hydride Vapor Phase Epitaxy) method will be described. In the HVPE method, an upright hot-wall type reactor (HVPE reactor) is employed. The HVPE reactor has a heater divided in the longitudinal direction around it, and it is capable of forming temperature distribution freely in the longitudinal direction. At an upper portion in the space inside the reactor, the HVPE reactor has a Ga metal boat in which Ga metal is placed. Below the metal boat, the HVPE reactor has a susceptor on which a sample is to be placed.

In the HVPE reactor, crystal growth is usually performed at the normal pressure (1 atm = 100 kPa). The Ga metal boat is heated to at least 800 °C so that Ga is molten. A gas introducing tube is provided at the upper portion of the reactor. From the gas introducing tube, a mixture gas of $H_2$ and HCl is blown into the Ga melt. Thus, GaCl is synthesized. GaCl is gaseous, and it falls downwardly to reach near the heated susceptor and the sample. Near the susceptor, a mixture gas of $H_2$ and $NH_3$ is blown. Reaction between GaCl and $NH_3$ produces GaN, which is deposited on the sample.

The mask pattern to be formed on the ground substrate is only necessary to be of a material inhibiting the epitaxial growth. Exemplary mask materials may be $SiO_2$, $Si_3N_4$, Pt, W and the like. The mask becomes a seed of crystal defect gathering region H. The crystal orientation of GaN is determined by the ground substrate. The orientation of the mask determines the plane orientation of the facet along the mask. Therefore, it is necessary to form a mask that has a constant relationship with respect to the crystal orientation of the ground substrate.

Example 1

In Example 1, the extent of the polarity reversed region formation by first growth temperature Te was considered.

1. Ground substrate (U)

As a ground substrate, 2-inch-diameter sapphire substrate (U1), GaAs substrate (U2), sapphire substrate (U3) on which a 1.5-$\mu$m-thick GaN epitaxial layer is formed through the MOCVD method were prepared. Sapphire substrate (U1) was a substrate of which main surface was C-plane ((0001) plane). GaAs substrate (U2) was a substrate of which main surface was (111) A-plane (Ga plane). GaN/sapphire substrate (U3) was a mirror-surface-like substrate in which GaN of the epitaxial layer was formed on C-plane ((0001) plane). Such a substrate provided with an epitaxial layer is also referred to as a template.

2. Mask Pattern

On each of these three types of ground substrates U1, U2 and U3, a 0.1-$\mu$m-thick $SiO_2$ thin film was formed through the plasma CVD method. By photolithography and etching, mask patterns were formed. The mask patterns were two types, i.e., stripe type (M1) and dot type (M2).

M 1: Stripe Type Mask Pattern

The parallel linear masks having a width as shown ion Fig. 8A being formed on ground substrate U is referred to as stripe type (M1) mask pattern. Masks M are arranged in parallel and with equal intervals. The portion not covered by the masks is the expose portion. Crystal growth starts from the expose portion.

When a GaN crystal is grown over the stripe masks, crystal defect gathering region H is formed on each mask as shown in Fig. 8B. Low defect single crystal region Z is formed at the portion that is over the expose portion and that is adjacent to the mask. In some cases, C-plane growth region Y is formed at the center of low-defect single crystal region Z, and in some cases it is not.

The orientation was determined such that the extending direction of the stripes was <1-100> direction of the GaN epitaxial layer. The GaN epitaxial layer is a layer deposited after the mask formation. On the other hand, it has been known that there is a constant relationship between the crystal orientation of the ground substrate and that of the GaN deposited thereon. Therefore, by determining the longitudinal direction of the mask based on the crystal orientation of the ground substrate, the mask can be set to extend in <1-100> direction of the GaN epitaxial layer that is grown thereafter.

In the case of GaN/sapphire substrate (U3), the orientation of mask extending direction is determined to be parallel with <1-100> direction of the GaN crystal. In the case of GaAs substrate (U2), the orientation of mask extending direction is determined to be parallel with <11-2> direction of the GaAs crystal. In the case of sapphire substrate (U1), the orientation of mask extending direction is determined to be parallel with <11-20> direction of the GaN crystal.

In stripe type (M1) mask pattern, width of a stripe-like cover portion ($SiO_2$), i.e., s = 30 $\mu$m, and repetition pitch of the stripe-like cover portion and expose portion, i.e., p = 300 $\mu$m. The expose portions also extend parallel with each other, and its width, i.e., e = 270 $\mu$m. That is, p = e + s. The pitch means a distance from the center of the cover portion to the center of the adjacent cover portion. The area ratio of the expose portion: the cover portion is 9:1.

M2: Dot Type Mask Pattern

Dots each having a certain diameter aligned with prescribed intervals to form a line is regarded as one unit. A large number of the units are aligned in parallel with each other. Fig. 9A shows an example of the dot type mask. On ground substrate U, small dot-like masks M are formed in a staggered manner. The cover portion is small, and most of the substrate is the expose portion. Growth starts from the expose portion.

A Gallium nitride wafer obtained by producing a gallium nitride crystal using the dot type mask and cutting the crystal in a direction perpendicular to c-axis has the structure as shown in Fig. 9B. Over each mask, crystal defect gathering region H is formed, around which low defect single crystal region Z is formed. The portion not covered by low defect single crystal region Z is C-plane growth region Y.

In the dot mask, for example, relative to a certain row of dots, an adjacent row of dots is formed such that dots thereof are present at the positions displaced half the pitch relative to the dots of the certain row. It is a pattern in which dots are present at the vertexes of a figure constituted of regular triangles arranged without a gap. That is, it is a pattern in which an arbitrarily specified dot and the nearest dot have a relationship of sixfold symmetry. The direction in which dots are aligned is determined to be parallel with, for example, <1-100> direction of a GaN crystal. While the GaN crystal is grown later also herein, the crystal orientation of the ground substrate and the crystal orientation of the GaN crystal have a certain relationship. Therefore, the direction of the mask pattern can be determined in association with the crystal orientation of the ground substrate so that the line of dots is parallel with <1-100> direction of the GaN crystal. When the ground substrate is sapphire substrate (U1), dots are aligned to be parallel with <11-20> direction of the sapphire substrate. When the ground substrate is GaAs (111) substrate (U2), dots are aligned to be parallel with <11-2> direction of the GaAs substrate.

Each dot (cover portion) is circular, dot diameter t = 50 $\mu$m, and dot pitch p = 300 $\mu$m, which is a distance between the centers of nearest dots. The length of the expose portion on a line connecting dots, i.e., f= 250 $\mu$m. The area of a unit regular triangle having three dots as the vertexes is 38971 $\mu$m$^2$. The area of one dot (cover portion) is 1963 $\mu$m$^2$. The area ratio of the expose portion: the cover portion is 19:1.

3. Growth for Buffer Layer Formation and Polarity Reversed Region Formation

In the HVPE reactor, the above-described substrates with masks (six types of substrates with masks, in which three types of ground substrates U1, U2 and U3 are each provided with two types of mask patterns M1 and M2) were placed.

Initially, a buffer layer of GaN was formed at a low temperature of about 500°C (Tb = 500 °C), with NH$_3$ gas partial pressure $P_{NH3}$ = 0.2 atm (20 kPa) and HCl gas partial pressure $P_{HCl}$ = 2 $\times$ 10$^{-3}$ atm (0.2 kPa), and with a growth time of 15 minutes. The thickness of the buffer layer was 60 nm.

Thereafter, the temperature was raised so that polarity reversed region formation temperature Tj = 1000 °C, and a polarity reversed region was grown over the mask and an epitaxial layer was grown over the expose portion for about one hour. The material gas was a mixture gas of H$_2$ and HCl, a mixture gas of H$_2$ and NH$_3$, and hydrocarbon gas. It was specified that NH$_3$ gas partial pressure $P_{NH3}$ = 0.2 atm (20 kPa) and HCl gas partial pressure $P_{HCl}$ = 2 $\times$ 10$^{-2}$ atm (2 kPa), and that the hydrocarbon gas was methane gas or ethane gas. For comparison, some samples were grown without supplying hydrocarbon gas. The process was ended after about one hour of growth, and without performing thick film growth, the samples were cooled and taken out from the reactor and observed. The preferable range of the polarity reversed region formation temperature is Tj = 970 °C - 1100 °C.

4. Type of Hydrocarbon Gas and Partial Pressure $P_{HC}$

In the present invention, in order to grow polarity reversed region J, fixed carbon or hydrocarbon gas is added. Methane (CH$_4$) gas, ethane (C$_2$H$_6$) gas, ethylene (C$_2$H$_4$) gas, acetylene (C$_2$H$_2$)gas or the like can be used as the material. When hydrocarbon gas falls within a range of $P_{HC}$ = 1 $\times$ 10$^{-4}$ atm (10 Pa) - 5 $\times$ 10$^{-2}$ atm (5 kPa), the effect of forming a polarity reversed region is attained. Here, the following three were tested.

(1) methane gas (CH$_4$)

$$P_{HC} = 8 \times 10^{-3} \text{ atm } (0.8 \text{ kPa})$$

(2) ethane gas (C$_2$H$_6$)

$$P_{HC} = 8 \times 10^{-3} \text{ atm } (0.8 \text{ kPa})$$

(3) without hydrocarbon gas

5. Crystal Growth for Allowing Polarity Reversed Region to be Formed

In light of past experience, it is known that the crystal growth for obtaining polarity reversed region J in which c-axis direction ([0001] direction) is rotated by 180° relative to regions (second crystal regions ZY) other than the polarity reversed region shows the following state. Fig. 7 shows a manner of the stripe facet growth. As shown in Fig. 7(a), stripe mask M is provided on the ground substrate. While only one mask is shown, actually there are many parallel masks. As shown in Fig. 7(b), growth of a gallium nitride crystal starts from the expose portion where the mask is not present. Without climbing on the mask, the crystal is formed in a thin-film manner over the entire expose portion. When the growth further progresses, a tilted plane of which lower end is the mask end is formed. This tilted plane is further grown without climbing on the mask, to form a clear facet F. This facet F has, for example, {11-22} plane orientation, while it is dependent on the orientation of the mask pattern. A crystal is not present over the mask, and facets F oppose to each other at both ends of the mask.

When polarity reversed region J in which c-axis direction is reversed by 180° is formed, as a precursor a rough protrusion is produced in the middle of the tilted plane of the facet. This is referred to as nail Q. As facets F are formed opposing to each other, nails Q are likewise formed opposing to each other (Fig. 7(c)). Nail Q is the seed of a polarity reversed region. If nail Q is not formed, a polarity reversed region is not formed later. The top plane of the protrusion (nail Q) forms a tilt angle of about 25° - 30° between the horizontal plane (C-plane). Nail Q (protrusion) formed in the middle of the facet is a crystal in which c-axis direction is reversed by 180° relative to the adjacent region portion under facet F. Since the crystal orientation is reversed, it becomes the seed of polarity reversed region J. Nail Q is grown, and the rough protrusion is enlarged. Then, nails Q extending from the opposing facets are integrated.

By the integration as shown in Fig. 7(d), the portion over the mask is closed. Nails Q are not in contact with the mask. They extend from the middle portion laterally and integrated with each other. The integrated portion becomes the seed of a crystal of the same orientation, which is grown in the longitudinal direction. Thus, over the mask, the crystal of the same crystal orientation as nails Q is formed. Since the nail is a crystal in which c-axis direction is reversed, the crystal formed thereon becomes polarity reversed region J. As shown in Fig. 7 (e), on nails Q, a crystal of the same orientation is grown longitudinally. The crystal is formed over the mask, and therefore it is crystal defect gathering region H (first crystal region). Thus, crystal defect gathering region H becomes polarity reversed region J. Over the expose portion on both sides, a more higher crystal already exists. The surface thereof is facet F. The crystal of the expose portion has a great amount of dislocations occurred at the boundary between the ground substrate. Dislocations extend upwardly as the growth progresses. Without burying the facet plane and while maintaining the facet, the growth is continued.

As the growth direction of the crystal in a facet is the normal line direction of the facet, dislocations also extend in the normal line direction as the crystal is grown.

Therefore, the direction in which dislocations extend is orthogonally outward. It exactly extends toward crystal defect gathering region H over the mask. Dislocations reach crystal defect gathering region H and are absorbed thereby. The dislocations absorbed by crystal defect gathering region H do not return to the facet again. Since they do not return, dislocations in the crystal region immediately under the facet are reduced. In the second crystal region grown over the expose portion, the portion grown under the facet is referred to as low crystal defect region portion Z. While this portion initially has a large number of dislocations between the ground substrate, as the facet is grown, dislocations are expelled externally and accumulated in crystal defect gathering region H, whereby a low density of dislocation is gradually attained in that portion. In the growth of a GaN crystal, crystal orientation is determined by the relationship with the ground substrate. Accordingly, the second crystal region grown over the plane region where the mask is not formed becomes a single crystal. Low crystal defect region portion Z has a low density of dislocations and is a single crystal, and therefore it is also referred to as a low defect single crystal region portion. The boundary between low crystal defect region portion Z and crystal defect gathering region H is crystal grain boundary K, K. Dislocations once captured by crystal defect gathering region H will not be separated. Thus, the density of dislocations further becomes lower in low crystal defect region portion Z.

Such facet growth continues until the end. Then, dislocations are efficiently expelled from the portion over the expose portion, low crystal defect region portion Z becomes a further excellent quality crystal with a low density of dislocations.

On the other hand, in some cases crystal defect gathering region H being a polarity reversed region is not successfully formed. The present invention is based on a finding that addition of carbon attains an effect of producing polarity reversed region J. At the initial stage of growth, carbon is doped to form a polarity reversed region, and thereafter thick film growth is performed without carbon doping, whereby an excellent quality crystal with a low density of dislocations is manufactured.

As the object of the present invention is to generate polarity reversed region J, without performing thick film growth, the samples were cooled and taken out from the reactor. Every GaN crystal showed a thickness of about 70 $\mu$m. The growth rate was about 70 $\mu$m/h.

6. Observation of Production/Non-Production of Polarity Reversed Region J over Mask

(1) In the case of methane gas ($CH_4$) $P_{HC}$ = 8 $\times$ 10$^{-3}$ atm (800 Pa)

Ground substrate: sapphire substrate (U1), GaAs substrate (U2), GaN/sapphire substrate (U3)

Mask pattern: stripe type mask (M1); dot type mask (M2)

Observation Result

M1 (stripe type mask): Polarity reversed regions were intermittently generated like a dashed line.

M2 (dot type mask): Polarity reversed regions were generated in most dots.

(2) In the case of ethane gas ($C_2H_6$) $P_{HC} = 8 \times 10^{-3}$ atm (800 Pa)

Ground substrate: sapphire substrate (U1), GaAs substrate (U2), GaN/sapphire substrate (U3)

Mask pattern: stripe type mask (M1), dot type mask (M2)

Observation Result

M1 (stripe type mask): Polarity reversed regions were intermittently generated like a dashed line.

M2 (dot type mask): Polarity reversed regions were generated in most dots.

(3) In the case of No Hydrocarbon $P_{HC} = 0$

Ground substrate: sapphire substrate (U1), GaAs substrate (U2), GaN/sapphire substrate (U3)

Mask pattern: stripe type mask (M1), dot type mask (M2)

Observation Result

M1 (stripe type mask): Polarity reversed regions were only intermittently generated.

M2 (dot type mask): Polarity reversed regions were only intermittently generated.

From the above observation results, the following was found. With the conditions above, when the carbon material gas was not supplied, the polarity reversed regions were only intermittently generated. Supplying the carbon material gas, formation of the polarity reversed region is facilitated. The material gas may be ethane gas or methane gas. When carbon material gas partial pressure $P_{HC} = 800$ Pa, although polarity reversed region spreads, regions where a polarity reversed region is not produced still remain, and the polarity reversed regions were intermittently present like a dashed line. Thus, it has been found that ethane gas and methane gas should be introduced at a higher partial pressure in order to produce the polarity reversed region over the entire mask.

Example 2

In Example 2, a case where a solid carbon plate is used as a material of carbon doping for forming a polarity reversed region was considered. Using the same reactor as Example 1 and with different growth rate, on sapphire substrate (U1), GaAs (111) substrate (U2), and GaN/sapphire substrate (U3) provided with stripe type mask (M1) and dot type mask (M2) by $SiO_2$ as in Example 1, a gallium nitride crystal was grown for 60 minutes while carbon was supplied. The difference from Example 1 was that the carbon material was not hydrocarbon gas, but a solid carbon plate. At a high temperature portion on slightly upstream side of a crystal growth portion (susceptor) in the HVPE reactor, the carbon plate was placed and a gallium nitride crystal was grown. Other conditions were the same as Example 1.

In the HVPE reactor, the above-described substrates with masks (six types of substrates, in which three types of ground substrates U1, U2 and U3 are each provided with two types of mask patterns M1 and M2) were placed.

Initially, a buffer layer of GaN was formed at a low temperature of about 500 °C (Tb = 500 °C), with $NH_3$ gas partial pressure $P_{NH3} = 0.2$ atm (20 kPa) and HCl gas partial pressure $P_{HCl} = 2 \times 10^{-3}$ atm (0.2 kPa), and with a growth time of 15 minutes. The thickness of the buffer layer was 60 nm.

Thereafter, the temperature was raised so that polarity reversed region formation temperature Tj = 1000 °C, and a polarity reversed region were grown over the mask and an epitaxial layer was grown over the expose portion for about one hour. It was specified that $NH_3$ gas partial pressure $P_{NH3} = 0.2$ atm (20 kPa), and HCl gas partial pressure $P_{HCl} = 2 \times 10^{-2}$ atm (2 kPa). The carbon material was the above-described carbon plate provided between a Ga reservoir and the susceptor. A material that contains carbon, such as a carbon plate, reacts with $NH_3$ gas under a high temperature atmosphere of, for example, 1000 °C and produces gas containing carbon, such as hydrocarbon gas. Such gas containing carbon is used as a carbon supplying source of doping. The process was ended after one hour of growth, and without performing thick film growth, the samples were cooled and taken out from the reactor and observed. The thickness of GaN was 70 $\mu$m.

Observation Result

Ground substrate: sapphire substrate (U1), GaAs substrate (U2), GaN/sapphire substrate (U3)

M1 (stripe type mask): Polarity reversed regions were intermittently present like a dashed line.

M2 (dot type mask): Polarity reversed regions were generated in most dots.

Similarly to the case of Example 1 in which hydrocarbon gas was supplied, it was confirmed that polarity reversed region J was formed over the mask also in Example 2 in which the carbon plate was employed as the carbon source. The results were similar and no significant difference were found among the cases respectively employing ground substrates of sapphire substrate (U1), GaAs substrate (U2), and GaN/sapphire substrate (U3). They did not turn black or yellow, and remained colorless and transparent.

After the crystal growth, the carbon plate placed in the reactor was taken out and weighed. The weight of the carbon plate was lighter after the crystal growth than before. As hydrogen is the carrier gas, it was assumed that all the components removed from the carbon plate turned to $CH_4$ (methane) gas. Considering the gas flow velocity, the partial pressure of methane was calculated as $1 \times 10^{-2}$ atm (1 kPa). This partial pressure falls within the aforementioned range of 10 Pa - 5 kPa.

From Example 2, it was found that a solid carbon source is similarly effective in forming a polarity reversed region. That is, it is not always necessary to supply the gaseous hydrocarbon gas as a carbon source.

It is noted that, when the solid carbon is placed in the reactor, carbon is doped also in thick film growth (several tens of hours - several thousands of hours) that follows the polarity reversed region formation (about 0.5 - 2 hours). When it is not preferable if the thick film growth portion of GaN contains carbon, the method of placing a carbon plate in the reactor is not appropriate.

Example 3

In Example 3, the relationship between hydrocarbon gas partial pressure and polarity reversed region formation was considered. To this end, varying the partial pressure (flow rate) of gaseous carbon material as in Example 1, the effect of a hydrocarbon gas partial pressure to formation of a polarity reversed region was examined. The same HVPE reactor as in Example 1 was used. As the ground substrate, GaAs (111) A-plane single crystal substrate (U2) was used. As the mask, dot type mask (M1) and stripe type mask (M2) were produced. Two types of substrates with mask, in which two types of mask patterns M1 and M2 were formed on ground substrate U2, were prepared, which were subjected to buffer layer formation and polarity reversed region formation. By varying the supply amount of hydrocarbon gas, how formation of a polarity reversed region changed correspondingly was examined.

The above-described samples were set in the HVPE reactor. Initially, a GaN buffer layer was formed at a low temperature of about 500 °C (Tb), with $NH_3$ gas partial pressure $P_{NH3}$ = 0.2 atm (20 kPa) and HCl gas partial pressure $P_{HCl}$ = $2 \times 10^{-3}$ atm (0.2 kPa), and with a growth time of 15 minutes. It is noted that $P_{NH3} / P_{HCl}$ = 100. The thickness of the buffer layer was 60 nm.

Thereafter, the temperature was raised, and then carbon was doped by methane gas to form polarity reversed region J. It was specified that growth temperature Tj = 1000 °C. It was specified that $NH_3$ gas partial pressure $P_{NH3}$ = 0.2 atm (20 kPa), and HCl gas partial pressure $P_{HCl}$ = $2 \times 10^{-2}$ atm (2 kPa). It is noted that $P_{NH3} / P_{HCl}$ = 10.

There is a constant relationship between a gas partial pressure and a flow rate. By controlling the flow rate using a mass flow controller or the like, gas is supplied. The total pressure in the HVPE apparatus is atmospheric temperature (1atm). Therefore, if the total flow rate is known, respective partial pressures of individual gases can be calculated therefrom. Respective gas partial pressures of $NH_3$, HCl, and $CH_4$ are the values calculated from the flow rate.

The growth time for polarity reversed region formation was 60 minutes. The thickness of the grown gallium nitride crystal was about 70μm. The growth rate was about 70 μm/h. It is noted that the methane gas partial pressure $P_{CH4}$ is the following seven, which are denoted by $P_{CH4(1)}$ - $P_{CH4(7)}$.

$$(1)\ P_{CH4(1)} = 5 \times 10^{-5}\ \text{atm (5 Pa)}$$

$$(2)\ P_{CH4(2)} = 1 \times 10^{-4}\ \text{atm (10 Pa)}$$

$$(3)\ P_{CH4(3)} = 1 \times 10^{-3}\ \text{atm (100 Pa)}$$

$$(4)\ P_{CH4(4)} = 5 \times 10^{-3}\ \text{atm (500 Pa)}$$

$$(5)\ P_{CH4(5)} = 1 \times 10^{-2}\ \text{atm (1 kPa)}$$

$$(6)\ P_{CH4(6)} = 5 \times 10^{-2}\ \text{atm (5 kPa)}$$

$$(7)\ P_{CH4(7)} = 1 \times 10^{-1}\ \text{atm (10 kPa)}$$

The samples were cooled and taken out from the reactor, and how the manner of production/non production of a polarity reversed region changed by the change in methane partial pressure $P_{CH4}$ was examined. The observation was conducted using a stereoscopic microscope and SEM.

(1) In the case of $P_{CH4(1)}$ = $5 \times 10^{-5}$ atm (5 Pa)

Observation Result
M1 (stripe type mask): Polarity reversed regions were only intermittently produced on the mask.
M2 (dot type mask): Polarity reversed regions were only intermittently produced on the mask.

(2) In the case of $P_{CH4(2)}$ = 1 × 10$^{-4}$ atm (10 Pa)

Observation Result
M1 (stripe type mask): Polarity reversed regions were intermittently present like a dashed line on the mask.
M2 (dot type mask): Polarity reversed regions were produced in most dot masks.

(3) In the case of $P_{CH4(3)}$ = 1 × 10$^{-3}$ atm (100 Pa)

Observation Result
M1 (stripe type mask): Polarity reversed regions were continuously present on the mask.
M2 (dot type mask): Polarity reversed regions were produced on all dot masks.

(4) In the case of $P_{CH4(4)}$ = 5 × 10$^{-3}$ atm (500 Pa)

Observation Result

M1 (stripe type mask): Polarity reversed regions were continuously present on the mask.

M2 (dot type mask): Polarity reversed regions were produced on all dot masks.

(5) In the case of $P_{CH4(5)}$ = 1 × 10$^{-2}$ atm (1 kPa)

Observation Result

M1 (stripe type mask): Polarity reversed regions were continuously present on the mask.

M2 (dot type mask): Polarity reversed regions were produced on all dot masks.

(6) In the case of $P_{CH4(6)}$ = 5 × 10$^{-2}$ atm (5 kPa)

Observation Result

M1 (stripe type mask): Polarity reversed regions were intermittently present like a dashed line and the color was black.

M2 (dot type mask): Polarity reversed regions were produced on part of the dot masks and the color was black.

(7) In the case of $P_{CH4(7)}$ = 1 × 10$^{-1}$ atm (10 Pa)

M1 (stripe type mask): Crack occurred over the entire surface and the color was black.

M2 (dot type mask): Crack occurred over the entire surface and the color was black.

The foregoing results were obtained, and it was found that when $P_{CH4(1)}$ = 5 Pa the polarity reversed regions were produced only intermittently and therefore not appropriate, and when $P_{CH4(7)}$ = 10 kPa the entire surface turned black and crack occurred and therefore not appropriate. Accordingly, it can be seen that the polarity reversed regions are formed over the mask in the range of $P_{CH4(2)}$ = 1 × 10$^{-4}$ atm (10 Pa)- $P_{CH4(6)}$ = 5 × 10$^{-2}$ atm (5 kPa).

It was found that the range of $P_{CH4(3)}$ = 1 × 10$^{-3}$ atm (100 Pa) - $P_{CH4(5)}$ = 1 × 10$^{-2}$ atm (1 kPa) allows the polarity reversed regions to be formed over all masks while black discoloring is prevented. That is, in order for the polarity reversed regions to be formed by carbon doping, the methane partial pressure must be 10 Pa - 5kPa, and more desirably, 100 Pa - 1kPa.

While it was found in the case in which gaseous hydrocarbon is the material, an equivalent effect is attained in a case where a solid carbon plate is placed in a reactor, which is heated to be reacted with hydrogen and supplied to samples as a carbon material, if a substantial partial pressure of hydrocarbon gas falls within this range.

Example 4

In Example 4, after formation of a buffer layer and a polarity reversed region, spending time, thick film growth was performed to obtain a GaN crystal. The GaN crystal was grinded and polished and formed as a wafer, of which property was examined.

Two types of substrates with masks, in which two types of mask patterns (that is, stripe type mask (M1), dot type mask (M2)) were formed on sapphire substrate (U1), were prepared. Similarly to Example 1, the two types of substrates with masks were placed in the susceptor of the HVPE reactor. A buffer layer was formed at a low temperature of temperature Tb = 500 °C, with $NH_3$ partial pressure $P_{NH3}$ = 0.2 atm (20 kPa) and HCl partial pressure $P_{HCl}$ = 2 × 10$^{-3}$ atm (200 Pa). The growth time was 15 minutes, and the thickness of the buffer layer was 60 nm.

Thereafter, the temperature was raised so that Tj = 1000 °C, and under conditions of $NH_3$ gas partial pressure $P_{NH3}$ = 0.2 atm (20 kPa), HCl gas partial pressure $P_{HCl}$ = 3 × 10$^{-2}$ atm (3 kPa), and methane gas partial pressure $P_{CH4}$ = 8 × 10$^{-3}$ atm (800 Pa), growth was performed for 15 hours. The samples were cooled and taken out from the reactor.

An about 1.5 mm-thick gallium nitride crystal formed on the ground substrate with masks was obtained. The growth rate was 100 μm/h. The gallium nitride crystal was observed using a stereoscopic microscope and/or SEM.

The obtained gallium nitride crystal was in the shape as shown in Fig. 6A or 6B. Fig. 6A shows a crystal formed on the ground substrate with the stripe type mask, while Fig. 6B shows a crystal formed on the ground substrate with the dot type mask. With the stripe type mask, a crystal in which ridges and troughs were repeated was obtained. With the dot type mask, a crystal with many isolated recesses was obtained. Recesses were observed on the surface corresponding to the position of the stripe and dot type masks. Referring to Fig. 5(c), it was confirmed that facet Fa of a small angle was formed at the bottom of a recess. Facet Fa is considered to be {11-2-6} plane having crystal orientation in which c-axis direction ([0001] direction) is reversed, in light of the angle between facet Fa and the main surface of the ground substrate. At the intermediate portion of the recess, facet F being more steeply tilted is present. It is considered to be {11-22} plane. From the foregoing, it can be seen that polarity reversed region J was formed on the mask.

By removing sapphire substrate (U1) from the gallium nitride crystal by grinding working, a free-standing crystal of gallium nitride was obtained. The surface of the free-standing crystal of gallium nitride was further subjected to grinding working and polishing working, and a crystal substrate having a flat surface was obtained. The crystal substrate was clearly transparent, and regions were not distinguishable from each other by naked eye.

The surface of the flat crystal was evaluated by an optical microscope and cathode luminescence (CL). As a result, in the sample in which stripe mask (M1) was used, linear recesses of about 20 $\mu$m width and being parallel with each other with a regular pitch of 300 $\mu$m were observed. This portion is crystal defect gathering region H. The recesses are attributed to {11-2-6} plane appearing on the surface, whereby it can be confirmed that crystal defect gathering region H is polarity reversed region J. The crystal has a repetition structure of HZYZHZYZ... as shown in Fig. 8B.

In the crystal substrate grown using dot type mask (M2) also, the diameter of a recess was about 30 $\mu$m - 40 $\mu$m, a pitch between the nearest recesses being 300 $\mu$m. An arbitrarily specified recess and the nearest recess have a relationship of sixfold symmetry. It exactly corresponds to the mask position. As shown in Fig. 9B, crystal defect gathering region H, low defect single crystal region Z and C-plane growth region Y forms a coaxial structure, around crystal defect gathering region H.

In CL image observation, threading dislocations exposed on the substrate surface appear as dark spots. Accordingly, the density of the threading dislocations can be measured by CL. The threading dislocation density was high in crystal defect gathering region H and was $10^7$ - $10^8$ cm$^{-2}$. The threading dislocation density was low in low defect single crystal region Z and C-plane growth region Y and was about $1 \times 10^5$ cm$^{-2}$. Thus, great low defect single crystal region Z in which threading dislocation density is sufficiently low was formed. While the gallium nitride crystal substrate obtained by the present invention is a substrate having an uneven structure, the positions of low defect single crystal region Z, crystal defect gathering region H, and C-plane growth region Y are clearly determined. Therefore, a gallium nitride crystal substrate having low density of dislocations for manufacturing a laser device of high quality can be provided.

In order to examine that carbon is surely doped in the crystal, element analysis of the crystal was conducted with SIMS (Secondary Ion Mass Spectroscopy).

As a result, it was found that carbon concentration in polarity reversed region J grown over the mask (crystal defect gathering region H) was $1 \times 10^{17}$ cm$^{-3}$. Carbon concentration in low defect single crystal region Z grown while a facet was maintained was $5 \times 10^{16}$ cm$^{-3}$. Carbon concentration in C-plane growth region Y was $4 \times 10^{18}$ cm$^{-3}$. Thus, it was confirmed that carbon was surely doped in the crystal. It was also found that efficiency of carbon introduction was largely different among the planes where crystal growth occurs.

Many experiments were further performed. As a result of reviewing the experiments, it was found that the carbon concentrations of polarity reversed region J (crystal defect gathering region H) and low defect single crystal region Z grown while a facet was maintained were lower than the carbon concentration of C-plane growth region Y. The carbon concentration of C-plane growth region Y was $10^{16}$ - $10^{20}$ cm$^{-3}$. a ratio of the carbon concentration of C-plane growth region portion Y to that of crystal defect gathering region H, and a ratio of the carbon concentration of C-plane growth region portion Y to that of low crystal defect region portion Z were both $10^1$ - $10^5$.

C-plane growth region Y was the highest in carbon concentration and in conductivity. It is considered that C-plane growth region Y compensates for carrier and has high resistance because the carbon impurity has deep light emission level.

Although the present invention has been described and illustrated in detail, it is clearly understood that the same is by way of illustration and example only and is not to be taken by way of limitation, the spirit and scope of the present invention being limited only by the terms of the appended claims. '

## Claims

1. A method of growing a gallium nitride crystal, comprising:

    a step of partially forming, on a ground substrate (U), a mask (M) inhibiting epitaxial growth of a gallium nitride crystal; and
    a step of epitaxially growing, while doping carbon, the gallium nitride crystal on said ground substrate (U) in which said mask (M) is formed, wherein
    in said step of epitaxially growing, a first crystal region is grown from a periphery of said mask (M) toward inside, and

c-axis direction is reversed in said first crystal region relative to a second crystal region grown on a region where said mask (M) is not formed in said ground substrate (U).

2. The method of growing a gallium nitride crystal according to claim 1, wherein

said first crystal region is formed by the crystals that are grown from the periphery of said mask (M) and that are integrated with each other above the mask so as to cover said mask (M), and

c-axis direction is reversed in said crystals relative to said second crystal region.

3. The method of growing a gallium nitride crystal according to claim 1, wherein

said first crystal region is grown at a facet (Fa) having {11-2-6} plane orientation.

4. The method of growing a gallium nitride crystal according to claim 1, wherein

said second crystal region includes a low crystal defect region portion (Z), said low crystal defect region portion (Z) being grown at a facet (F) having {11-22} plane orientation.

5. The method of growing a gallium nitride crystal according to claim 1, further comprising,

after said step of partially forming the mask (M) and before said step of epitaxially growing, a step of growing, on said ground substrate (U) in which said mask (M) is formed, a buffer layer of gallium nitride having a thickness of at most 200 nm at a low temperature of 400 °C - 600 °C.

6. The method of growing a gallium nitride crystal according to claim 1, wherein

a crystal growing temperature in said step of epitaxially growing is 900 °C - 1100 °C.

7. The method of growing a gallium nitride crystal according to claim 1, wherein

said ground substrate (U) is any of a sapphire substrate, a Si substrate, a SiC substrate, a GaN substrate, a GaAs substrate, and a heterogeneous substrate having a GaN thin film grown on its surface.

8. The method of growing a gallium nitride crystal according to claim 1, wherein

said growth of the gallium nitride crystal is performed by Hydride vapor phase epitaxy method.

9. The method of growing a gallium nitride crystal according to claim 1, wherein

said doping of carbon is performed by introducing hydrocarbon gas into a reactor.

10. The method of growing a gallium nitride crystal according to claim 9, wherein

said hydrocarbon gas includes any of $CH_4$, $C_2H_6$, and $C_2H_4$.

11. The method of growing a gallium nitride crystal according to claim 9, wherein

a partial pressure of said hydrocarbon gas introduced into said reactor is $1 \times 10^{-4}$ atm - $5 \times 10^{-2}$ atm.

12. The method of growing a gallium nitride crystal according to claim 1, wherein

in said doping of carbon, a material containing carbon is placed in a reactor so that gas containing carbon that is produced from the material containing carbon serves as a carbon source.

13. The method of growing a gallium nitride crystal according to claim 12, wherein

a partial pressure of said gas containing carbon is $1 \times 10^{-4}$ atm - $5 \times 10^{-2}$ atm.

14. A gallium nitride crystal substrate, comprising

a first crystal region having a crystal defect gathering region (H), and

a second crystal region having a low crystal defect region portion (Z) and a C-plane growth region portion (Y), wherein

ratios of a carbon concentration of said C-plane growth region portion (Y) to that of said crystal defect gathering region (H) and to that of said low crystal defect region portion (Z) are $10^1$ - $10^5$.

FIG.1

(a)

C-PLANE

AVERAGE GROWTH
DIRECTION

7

6

6

5

8

6

Θ

D

D

9

4

4

(b)

AVERAGE GROWTH
DIRECTION

6

6

5

8

6

Θ

C-PLANE

7

D

4

9

10

11

## FIG.2

MOVEMENT OF DISLOCATION IN FACET PIT

## FIG.3

(a)

DISLOCATION
GATHERING BUNDLE

(b)

SMOKE-LIKE SPREAD

## FIG.4

(a)

(b)

## FIG.5

(a)

(b)

(c)

## FIG.6A

## FIG.6B

## FIG.7

FIG.8A

FIG.8B

FIG.9A

FIG.9B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9923693 A
- JP 2001102307 A
- JP 2003165799 A
- JP 2003183100 A
- JP 2006066496 A